# DEMANDE DE BREVET EUROPEEN

(11) **EP 1 783 815 A1**
(43) Date de publication de la demande: **09.05.2007**
(21) Numéro de dépôt: 05292355.4
(22) Date de dépôt: 07.11.2005
(51) Int. Cl.: H01J 37/34

(54) **Procédé et installation d'avivage sous vide par pulvérisation magnétron d'une bande métallique**

(71) Demandeur: ARCELOR France, 93212 La Plaine Saint Denis Cedex (FR)
(72) Inventeur: Cornil, Hugues, 4570 Marchin (BE); Deweer, Benoît, 1970 Wezembeek-Oppem (BE); Maboge, Claude, 5650 Castillon (BE)
(74) Mandataire: Plaisant, Sophie Marie

(57) **Abrégé**

L'invention concerne un procédé d'avivage sous vide par pulvérisation magnétron d'une bande métallique (2) défilant au-dessus d'au moins une contre-électrode (3, 3') en matériau conducteur dans une enceinte sous vide (1), dans lequel on crée un plasma dans un gaz à proximité de ladite bande métallique (2), de manière à générer des radicaux et/ou des ions agissant sur cette bande métallique (2), un circuit magnétique de confinement (4) étant placé au-dessus de ladite bande métallique (2), caractérisé en ce que ladite contre-électrode (3, 3') présente une surface mobile, en rotation et/ou en translation, par rapport à ladite bande métallique (2), ladite surface étant mise en mouvement lors de l'avivage et étant nettoyée en continu par un dispositif de nettoyage (5, 5') placé dans l'ombre dudit plasma avant d'être à nouveau exposée audit plasma. Elle concerne également une installation d'avivage pour la mise en oeuvre du procédé.

## Description

La présente invention concerne un procédé et une installation d'avivage sous vide par pulvérisation magnétron d'une bande métallique, telle qu'une bande d'acier, par exemple.

Lors des opérations de revêtement sous vide d'une bande d'acier, l'état de propreté de la bande avant dépôt est l'un des facteurs clés de réussite, car il détermine la bonne adhérence du revêtement à déposer. Un des procédés utilisés pour ce faire est l'avivage sous vide par pulvérisation magnétron encore appelé etching. Ce procédé consiste à créer un plasma entre la bande et une contre-électrode, dans un gaz permettant de générer des radicaux et/ou ions. Ces ions vont, dans les conditions normales de fonctionnement, être accélérés vers la surface de la bande à décaper, et venir arracher des atomes superficiels, nettoyant ainsi la surface éventuellement souillée, tout en l'activant.

La bande à décaper se déplace dans une chambre sous vide en regard d'une contre-électrode. Cette dernière est polarisée positivement par rapport à la bande métallique, elle-même préférentiellement reliée à la masse. Un ensemble d'aimants positionné à l'arrière de la bande confine le plasma créé auprès de celle-ci. Afin de positionner de façon très précise la bande métallique à traiter, par rapport à la contre-électrode nécessaire à la mise en oeuvre de la pulvérisation magnétron, la bande métallique est généralement disposée sur un rouleau d'appui qui peut être mis en rotation autour de son axe. Ce type de rouleau n'est cependant pas nécessaire lorsque l'on traite des bandes métalliques en forme de plaques rigides.

Le problème qui se pose cependant lors de l'application de cette technique pour le nettoyage d'une bande métallique telle qu'une bande d'acier en défilement continu est l'encrassement de la contre-électrode. Lors du procédé d'avivage, les particules érodées de la surface de la bande se déposent sur les parties en vis à vis, c'est à dire sur la contre-électrode, et la couvrent avec le temps d'un film noir peu adhérent. Celui-ci finit par se craqueler et peler en formant des copeaux pulvérulents initiateurs d'arcs. La formation d'arcs peut provoquer :
- d'une part un endommagement de la surface de la bande d'acier à l'endroit où l'arc est initié,
- d'autre part un défaut d'avivage sur une petite surface de la bande en défilement de par la suspension de courte durée (100 µs environ) de l'alimentation en courant par le générateur lors de la détection de l'arc.

Enfin, lorsqu'il est diélectrique, le dépôt peut isoler l'électrode et gêner le fonctionnement du plasma.

Le maintien d'un bon état de propreté de la contre électrode lors du procédé d'avivage s'avère donc indispensable.

On connaît le document EP-A-0 908 535 qui décrit un procédé de décapage de la surface d'une bande métallique contaminée par une couche mince d'oxyde. Les contre-électrodes mises en oeuvre sont utilisées par paires reliées à un générateur de courant alternatif. Elles ont une forme plate ou arrondie et permettent d'éviter la formation d'arcs pendant un certain temps. Au bout d'une certaine durée de mise en service, ces électrodes s'encrassent, ce qui oblige à interrompre le procédé pour les nettoyer ou bien à diminuer la puissance de l'avivage, ce qui nuit de toutes les façons à son efficacité et/ou à sa qualité.

La présente invention a donc pour but de remédier aux inconvénients de procédés de l'art antérieur en mettant à disposition un procédé et une installation d'avivage sous vide par sputtering magnétron de la surface d'une bande métallique en défilement, qui permette d'améliorer la qualité et l'efficacité de l'avivage en évitant tout endommagement de la bande métallique et tout défaut d'avivage dus à la formation intempestive d'arcs électriques, et ce, sans interruption du procédé.

A cet effet, l'invention a pour premier objet un procédé d'avivage sous vide par pulvérisation magnétron d'une bande métallique défilant au-dessus d'au moins une contre-électrode en matériau conducteur dans une enceinte sous vide, dans lequel on crée un plasma dans un gaz à proximité de ladite bande métallique, de manière à générer des radicaux et/ou des ions agissant sur cette bande métallique, un circuit magnétique de confinement étant placé au-dessus de la bande métallique, dans lequel la contre-électrode présente une surface mobile, en rotation et/ou en translation, par rapport à la bande métallique, la surface étant mise en mouvement lors de l'avivage et étant nettoyée en continu par un dispositif de nettoyage placé dans l'ombre du plasma avant d'être à nouveau exposée au plasma.

Le procédé selon l'invention peut en outre incorporer les caractéristiques suivantes, prises isolément ou en combinaison :
- le dispositif de nettoyage est un dispositif de nettoyage à action mécanique localisée.
- le dispositif de nettoyage est constitué d'une racle rigide en contact avec la surface mobile de la contre-électrode.
- les matières décollées de la surface mobile de la contre-électrode par l'action du dispositif de nettoyage sont récupérées à l'aide d'un dispositif de collecte placé en partie basse de ladite enceinte sous vide.
- la contre-électrode est polarisée positivement par rapport à la bande métallique, la bande métallique pouvant être reliée ou non à la masse.
- la contre-électrode est soumise à un potentiel alternatif, la bande métallique pouvant être reliée ou non à la masse.
- l'enceinte sous vide est munie d'une contre-électrode constituée d'au moins deux cylindres rotatifs et d'une courroie tendue sur les cylindres.
- on refroidit la ou les contre-électrodes.

Un second objet de l'invention est constitué par une installation d'avivage par pulvérisation magnétron d'une bande métallique comprenant une enceinte sous vide à l'intérieur de laquelle se trouve au moins une contre-électrode, des moyens de polarisation de la bande métallique, des moyens de polarisation de la contre-électrode, des moyens permettant de créer un plasma dans un gaz entre la bande métallique et la contre-électrode, au moins un circuit magnétique de confinement étant placé au-dessus de la bande métallique et la contre-électrode présentant une surface mobile en rotation et/ou en translation par rapport à la bande métallique, ainsi qu'un dispositif de nettoyage de la surface mobile, placé dans l'ombre du plasma.

L'installation selon l'invention peut en outre incorporer les caractéristiques suivantes, prises isolément ou en combinaison :
- le dispositif de nettoyage est un dispositif de nettoyage à action mécanique localisée,
- le dispositif de nettoyage est constitué d'une racle rigide en contact avec la surface mobile de la contre-électrode,
- l'enceinte sous vide comprend en outre un dispositif de collecte des matières décollées de la surface mobile de la contre-électrode par l'action du dispositif de nettoyage, le dispositif de collecte étant placé en partie basse de ladite enceinte sous vide,
- la contre-électrode est polarisée positivement par rapport à la bande métallique, ladite bande métallique pouvant être reliée ou non à la masse,
- la contre-électrode est soumise à un potentiel alternatif, la bande métallique pouvant être reliée ou non à la masse,
- l'enceinte sous vide est munie d'une contnr-électrode constituée d'au moins deux cylindres rotatifs et d'une courroie tendue sur les cylindres,
- la contre-électrode est munie de moyens de refroidissement.

L'invention va à présent être décrite plus en détail en référence aux figures annexées qui représentent :
- figure 1 : vue schématique en coupe d'un mode de réalisation d'une installation selon l'invention,
- figure 2: vue schématique en coupe d'un second mode de réalisation d'une installation selon l'invention,

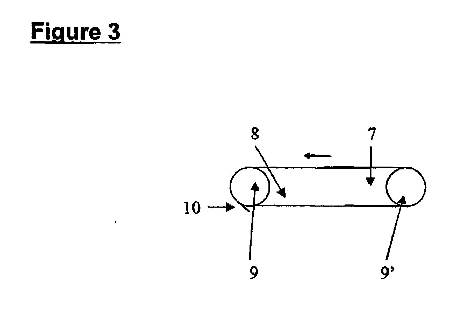

- figure 3 : vue schématique en coupe d'un troisième mode de réalisation d'une installation selon l'invention.

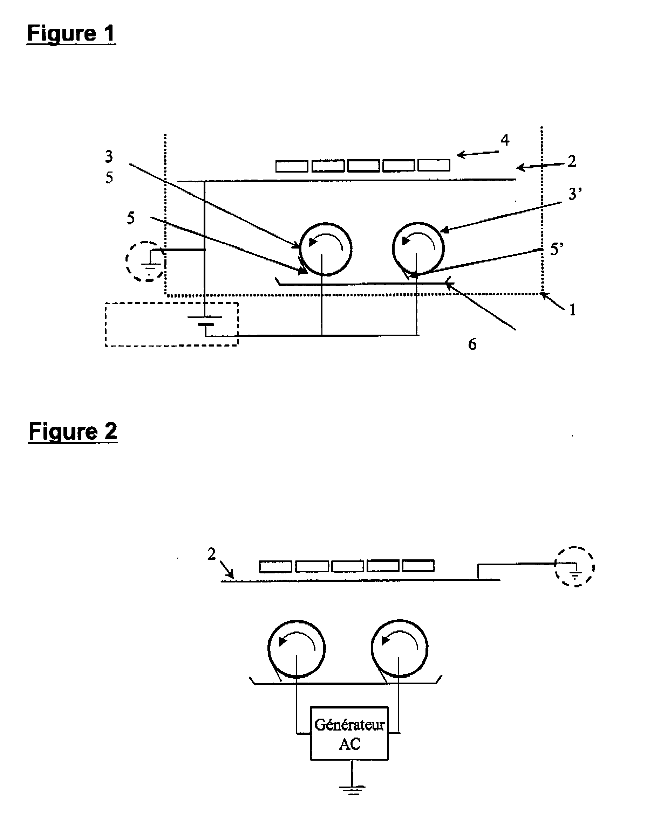

Si l'on considère tout d'abord la figure 1, on peut y voir une enceinte sous vide 1 à l'intérieur de laquelle une bande métallique 2, telle qu'une bande en acier défile. Dans la partie basse de cette enceinte sous vide 1, se trouvent deux contre-électrodes 3 et 3' de forme cylindrique qui peuvent être mise en rotation autour de leurs axes. Les contre-électrodes 3, 3' doivent être en matériau conducteur. Bien qu'un matériau ferromagnétique puisse convenir, il est conseillé d'utiliser un matériau non ferromagnétique afin de ne pas perturber le confinement magnétique du plasma.

Les contre-électrodes 3, 3' sont soumises à un échauffement qui implique de les refroidir dans certains cas. Elles sont entraînées en rotation, par exemple de façon mécanique par le défilement de la bande métallique 2. Les contre-électrodes 3, 3' peuvent également être entraînées par un moteur électrique placé sous vide, un moteur pneumatique, un moteur hydraulique ou par un passage tournant sous vide.

La bande métallique 2 est reliée à la masse tandis que les contre-électrodes 3, 3' sont polarisées positivement.

Au-dessus de cette bande 2, se trouve un circuit magnétique 4 prenant la forme d'aimants qui servent à confiner le plasma à proximité de la bande métallique 2.

Chaque contre-électrode 3, 3' est munie d'une racle 5, 5' placées dans l'ombre du plasma d'avivage de la bande métallique 2. La réalisation de la fixation des racles 5, 5' doit être particulièrement soignée pour éviter de créer un court-circuit entre les contre-électrodes 3, 3' et les autres pièces du montage, ceci même après métallisation des surfaces internes de la cellule par les particules conductrices décapées. Des chicanes anti-métallisation peuvent être disposées autour des isolateurs. Ces chicanes se situent entre la paroi de l'enceinte 1 et les racles 5, 5' afin des les isoler mutuellement. Le support des racles 5, 5' ne sont ainsi pas métallisés, ce qui évite tout court-circuit.

Les racles 5, 5' peuvent être réalisées en tout matériau adapté à condition qu'il ne soit pas conducteur. On pourra notamment les réaliser en céramique ou en verre.

Des précautions peuvent en outre être prises pour que les racles 5, 5' ne projettent pas de copeaux vers la bande métallique 2, même après rebond.

L'enceinte sous vide 1 comprend également un bac 6 de récupération des matières décollées par les racles 5, 5'.

Lorsque la bande métallique 2 est avivée dans l'enceinte sous vide 1, on fait tourner les contre-électrodes 3, 3' dans un mouvement relativement lent, de sorte qu'elles sont continuellement nettoyées au moyen des racles 5, 5'. Les matières décollées par ces moyens tombent dans le bac 6 qui peut être régulièrement vidé.

Si l'on considère à présent la figure 2, on peut y voir un second mode de réalisation de l'invention, dans lequel on applique aux contre-électrodes 3, 3' un potentiel alternatif, la bande métallique 2 en défilement étant ou non reliée à la masse.

Le système peut être constitué d'une ou plusieurs contre-électrodes. Comme on peut le voir sur la vue partielle de la figure 4, la contre-électrode 7 peut également être constituée d'une courroie 8 tendue entre deux cylindres 9, 9' et entraînée suivant le principe du « tapis roulant ». Une racle 10 placée dans l'ombre du plasma permet de nettoyer la courroie lorsqu'elle défile dans l'enceinte sous vide 1.

### Exemple de réalisation

Un indicateur de l'efficacité d'un système d'avivage peut être la puissance maximum que l'on peut appliquer à la cellule d'avivage sans formation d'arcs.

On a donc procédé à un essai dans lequel on a mesuré cette puissance maximum pour une cellule d'avivage classique et pour une cellule d'avivage telle que représentée à la figure 1.

On a ainsi pu mesurer que la puissance maximum stable dans le temps, d'une installation d'avivage selon l'invention représente plus du double de celle d'une installation classique présentant une contre-électrode plane et fixe.

La vitesse d'érosion par avivage magnétron d'une bande métallique étant liée à la puissance appliquée, l'utilisation des contre-électrodes selon l'invention permet de doubler l'efficacité de l'avivage.

Le système de contre-élecfirodes présenté ci-dessus reste propre au court du temps et évite l'apparition d'arcs à partir de particules issues de l'avivage de la surface de la bande métallique ou le problème d'anode disparaissante.

## Revendications

1. Procédé d'avivage sous vide par pulvérisation magnétron d'une bande métallique (2) défilant au-dessus d'au moins une contre-électrode (3, 3', 7) en matériau conducteur dans une enceinte sous vide (1), dans lequel on crée un plasma dans un gaz à proximité de ladite bande métallique (2), de manière à générer des radicaux et/ou des ions agissant sur cette bande métallique (2), un circuit magnétique de confinement (4) étant placé au-dessus de ladite bande métallique (2), **caractérisé en ce que** ladite contre-électrode (3, 3', 7) présente une surface mobile, en rotation et/ou en translation, par rapport à ladite bande métallique (2), ladite surface étant mise en mouvement lors de l'avivage et étant nettoyée en continu par un dispositif de nettoyage (5, 5', 10) placé dans l'ombre dudit plasma avant d'être à nouveau exposée audit plasma.

2. Procédé d'avivage selon la revendication 1, dans lequel ledit dispositif de nettoyage (5, 5', 10) est un dispositif de nettoyage à action mécanique localisée.

3. Procédé d'avivage selon la revendication 2, dans lequel ledit dispositif de nettoyage (5, 5', 10) est constitué d'une racle rigide en contact avec la surface mobile de ladite contre-électrode (3, 3', 7).

4. Procédé d'avivage selon l'une quelconque des revendications 1 à 3, dans lequel les matières décollées de la surface mobile de ladite contre-électrode (3, 3', 7) par l'action dudit dispositif de nettoyage (5, 5', 10) sont récupérées à l'aide d'un dispositif de collecte (6) placé en partie basse de ladite enceinte sous vide (1).

5. Procédé d'avivage selon l'une quelconque des revendications 1 à 4, dans lequel ladite contre-électrode (3, 3', 7) est polarisée positivement par rapport à la bande métallique (2), ladite bande métallique (2) pouvant être reliée ou non à la masse.

6. Procédé d'avivage selon l'une quelconque des revendications 1 à 4, dans lequel ladite contre-électrode (3, 3', 7) est soumise à un potentiel alternatif, la bande métallique (2) pouvant être reliée ou non à la masse.

7. Procédé selon l'une quelconque des revendications 1 à 6, dans lequel l'enceinte sous vide (1) est munie d'une contre-électrode (7) constituée d'au moins deux cylindres rotatifs (9, 9') et d'une courroie (8) tendue sur lesdits cylindres (9, 9').

8. Procédé selon l'une quelconque des revendications 1 à 7, dans lequel on refroidit ladite contre-électrode (3, 3', 7).

9. Procédé selon l'une quelconque des revendications 1 à 8, dans lequel ladite bande métallique (2) est une bande d'acier.

10. Installation d'avivage sous vide par pulvérisation magnétron d'une bande métallique (2) comprenant une enceinte sous vide (1) à l'intérieur de laquelle se trouve au moins une contre-électrode (3, 3', 7), des moyens de polarisation de ladite bande métallique, des moyens de polarisation de ladite contre-électrode (3, 3', 7), des moyens permettant de créer un plasma dans un gaz entre ladite bande métallique (2) et ladite contre-électrode (3, 3', 7), au moins un circuit magnétique de confinement (4) étant placé au-dessus de ladite bande métallique (2) et ladite contre-électrode (3, 3', 7)présentant une surface mobile en rotation et/ou en translation par rapport à ladite bande métallique (2), ainsi qu'un dispositif de nettoyage (5, 5', 10) de ladite surface mobile, placé dans l'ombre dudit plasma.

11. Installation d'avivage selon la revendication 10, dans laquelle ledit dispositif de nettoyage (5, 5', 10) est un dispositif de nettoyage à action mécanique localisée.

12. Installation d'avivage selon la revendication 11, dans laquelle ledit dispositif de nettoyage (5, 5', 10) est constitué d'une racle rigide en contact avec la surface mobile de ladite contre-électrode (3, 3', 7).

13. Installation d'avivage selon l'une quelconque des revendications 10 à 12, dans laquelle l'enceinte sous vide (1) comprend en outre un dispositif de collecte (6) des matières décollées de la surface mobile de ladite contre-électrode (3, 3', 7) par l'action dudit dispositif de nettoyage (5, 5', 10), ledit dispositif de collecte (6) étant placé en partie basse de ladite enceinte sous vide (1).

14. Installation d'avivage selon l'une quelconque des revendications 10 à 13, dans laquelle ladite contre-électrode (3, 3', 7) est polarisée positivement par rapport à la bande métallique (2), ladite bande métallique (2) pouvant être reliée ou non à la masse.

15. Installation d'avivage selon l'une quelconque des revendications 10 à 13, dans laquelle ladite contre-électrode (3, 3', 7) est soumise à un potentiel alternatif, la bande métallique (2) pouvant être reliée ou non à la masse.

16. Installation selon l'une quelconque des revendications 10 à 15, dans laquelle l'enceinte sous vide (1) est munie d'une contre-électrode (7) constitué d'au moins deux cylindres rotatifs (9, 9') et d'une courroie (8) tendue sur lesdits cylindres (9, 9').

17. Installation selon l'une quelconque des revendications 10 à 16, dans laquelle ladite contre-électrode (3, 3', 7) est munie de moyens de refroidissement.
